(19) **Europäisches Patentamt**
**European Patent Office**
**Office européen des brevets**

(11) **EP 3 729 109 B1**

(12) **FASCICULE DE BREVET EUROPEEN**

(45) Date de publication et mention de la délivrance du brevet:
**05.01.2022 Bulletin 2022/01**

(21) Numéro de dépôt: **18822321.8**

(22) Date de dépôt: **12.12.2018**

(51) Int Cl.:
*G01R 21/00* (2006.01)     *G01R 31/34* (2020.01)
*G01R 21/133* (2006.01)    *G01R 22/10* (2006.01)

(86) Numéro de dépôt international:
**PCT/EP2018/084484**

(87) Numéro de publication internationale:
**WO 2019/121203 (27.06.2019 Gazette 2019/26)**

(54) **PROCÉDÉ DE MESURE, PROGRAMME ET DISPOSITIF DE MESURE DE PUISSANCE OU ÉNERGIE DE MOTEUR ÉLECTRIQUE**

MESSVERFAHREN, PROGRAMM UND VORRICHTUNG ZUR MESSUNG DER LEISTUNG ODER ENERGIE EINES ELEKTROMOTORS

MEASUREMENT METHOD, PROGRAM AND DEVICE FOR MEASURING POWER OR ENERGY OF AN ELECTRIC MOTOR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **19.12.2017 FR 1762453**

(43) Date de publication de la demande:
**28.10.2020 Bulletin 2020/44**

(73) Titulaire: **Electricité de France**
**75008 Paris (FR)**

(72) Inventeurs:
• **LANGLET, Jérémy**
  **92410 VILLE D'AVRAY (FR)**
• **ARRAS, Abdessalim**
  **91200 ATHIS MONS (FR)**

(74) Mandataire: **Regimbeau**
**Parc d'affaires Cap Nord A**
**2, allée Marie Berhaut**
**CS 71104**
**35011 Rennes Cedex (FR)**

(56) Documents cités:
**EP-A1- 2 549 280     FR-A1- 2 999 326**

EP 3 729 109 B1

**Description**

L'invention concerne un procédé et un dispositif de mesure de grandeurs électriques d'un moteur électrique.

Le domaine de l'invention concerne tous les types de moteurs électriques, notamment les moteurs électriques asynchrones.

La plupart des moteurs électriques comportent une plaque signalétique mentionnant la puissance nominale du moteur, la vitesse nominale du moteur, la tension nominale du moteur, le courant nominal du moteur et le facteur de puissance du moteur.

La consommation électrique des moteurs représente plus de 70% de la facture des industriels. Cette part peut être significativement réduite en optimisant la régulation et le dimensionnement des moteurs. En effet, il y a un grand gisement d'économie d'énergie car de nombreux moteurs sont régulés par des procédés mécaniques qui fondent leurs régulations sur des pertes de charges plutôt que sur la variation de vitesse de rotation du moteur. Pourtant l'utilisation d'un variateur électronique de vitesse permet d'économiser jusqu'à 30% de la consommation. De plus, par méconnaissance du travail fourni par le moteur, les industriels ont tendances à les sur-dimensionner, ce qui a pour effet de dégrader leurs rendements globaux.

Le remplacement d'un moteur et/ou de sa régulation représente un investissement qu'il faut amortir. Or, selon que la charge du moteur est fortement variable ou non, les économies de consommation peuvent être complètement différentes pour deux moteurs identiques ayant le même type de régulation.

Actuellement, relativement peu de mesures de grandeurs électriques telles que la puissance active et/ou la puissance mécanique et/ou l'énergie active et/ou l'énergie mécanique sont réalisées sur le moteur électrique du fait de la complexité de mise en œuvre, du caractère intrusif de la méthode et de la méconnaissance générale du fonctionnement des moteurs. En effet, pour mesurer la puissance d'un moteur dans le temps, l'utilisation d'un wattmètre impose l'installation de trois pinces de courant et de trois sondes de tension qui, sans compter le risque d'erreur de câblage, impliquent parfois l'arrêt de la production. De plus, les wattmètres traditionnels ont besoin d'une source d'alimentation électrique qui leur est propre (le plus souvent en 220V), ce qui n'est pas courant dans l'industrie.

Le document FR-A-2 999 326 décrit un système de surveillance d'un dispositif électrique, le système comportant pour chaque dispositif électrique un capteur associé ayant pour fonction de fournir au moins une valeur de mesure d'un courant électrique de ce dispositif électrique, le capteur étant associé à un organe de transmission sans fil de la valeur de mesure du courant électrique fournie par le capteur à un organe récepteur distant relié à un calculateur, comportant des moyens de calcul d'au moins un paramètre de fonctionnement du dispositif électrique, autre que son courant électrique, à partir de la valeur de mesure de courant électrique reçue de l'organe récepteur et à partir d'au moins une caractéristique prédéterminée du dispositif électrique, enregistrée dans une mémoire, cette caractéristique étant une fonction polynomiale de degré 2 de la valeur de mesure du courant électrique. Le paramètre de fonctionnement est une puissance active et/ou une puissance active relative du moteur électrique ou un paramètre sur le fonctionnement d'une machine entraînée par un moteur électrique du dispositif électrique, comme par exemple le débit hydraulique lorsqu'il s'agit d'une pompe, le débit d'air lorsqu'il s'agit d'un compresseur, ou autres. Ces paramètres sont calculés en fonction de la ou des valeurs de mesure du courant et en fonction de caractéristiques sur le courant à vide, la puissance nominale, le courant nominal, le facteur de puissance, la tension d'alimentation, la vitesse de synchronisme.

L'inconvénient du système de surveillance selon le document FR-A-2 999 326 est que les erreurs de conversion du courant en ledit paramètre peuvent être différentes d'un moteur à l'autre et ont tendance à croître si la puissance délivrée par le moteur diminue.

L'invention vise à obtenir un procédé et un dispositif de mesure de la puissance active et/ou de la puissance mécanique et/ou de l'énergie active et/ou de l'énergie mécanique du moteur électrique, qui pallie les inconvénients de l'état de la technique, en étant simple à mettre en œuvre, peu intrusif et en améliorant la mesure pour tenir compte de la diversité des moteurs électriques.

A cet effet, un premier objet de l'invention est un procédé de mesure d'une puissance active et/ou d'une puissance mécanique et/ou d'une énergie active et/ou d'une énergie mécanique d'un moteur électrique, dans lequel

on mesure un courant réel du moteur par au moins un capteur de mesure,
caractérisé en ce que
l'on entre sur au moins une interface d'entrée d'un calculateur au moins une donnée de puissance nominale du moteur, une donnée de vitesse nominale du moteur, une donnée de courant nominal du moteur, une donnée de tension nominale du moteur, une donnée de facteur de puissance du moteur et le courant réel du moteur, on calcule dans le calculateur un courant à vide du moteur selon une première fonction enregistrée dépendant au moins de la donnée de puissance nominale du moteur, de la donnée de courant nominal du moteur, de la donnée de tension nominale du moteur et de la donnée de facteur de puissance du moteur,
on calcule dans le calculateur la puissance active et/ou la puissance mécanique et/ou l'énergie active et/ou l'énergie mécanique selon au moins une deuxième fonction enregistrée dépendant au moins de la donnée de puissance nominale du moteur, de la donnée de courant nominal du moteur, du courant réel et du courant à vide ayant été calculé,

on fournit sur une interface de sortie du calculateur la puissance active et/ou la puissance mécanique et/ou l'énergie active et/ou l'énergie mécanique, ayant été calculée.

Les inventeurs, par l'analyse d'un grand nombre de moteurs électriques, ont déterminé que le calcul de la puissance active et/ou de la puissance mécanique et/ou de l'énergie active et/ou de l'énergie mécanique dans chaque plage de vitesse de rotation était gouverné par les deux première et deuxième fonctions précitées, avec le fait que le courant à vide dépend des données nominales précitées sans dépendre du courant réel mesuré, alors que la puissance dépend du courant à vide, du courant réel mesuré et d'une partie des données nominales.

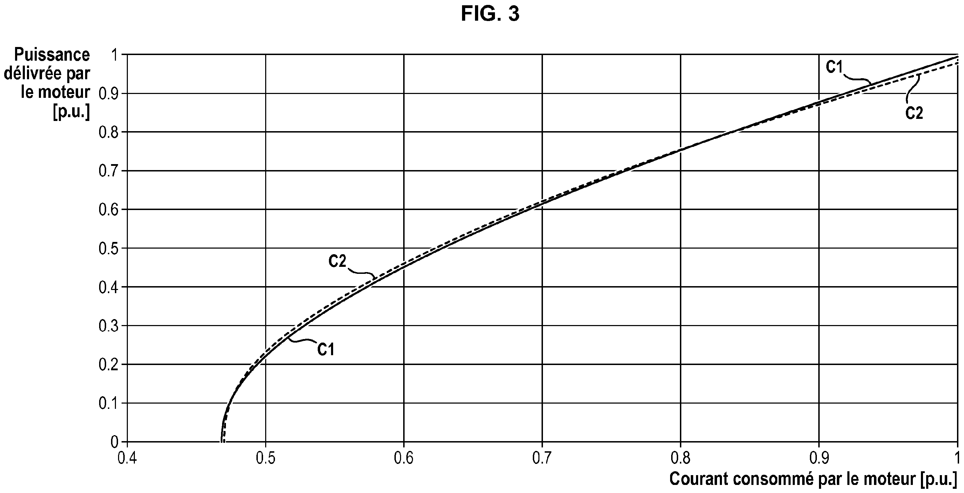

Différentes simulations effectuées ont montré que les différentes courbes d'évolution de la puissance en fonction du courant réel mesuré ne sont pas directement liées aux données nominales des moteurs. Par exemple, sur la figure 3, les courbes C1 et C2 d'évolution de respectivement deux exemples de moteurs appelés moteur 1 et moteur 2 sont très semblables, alors que ces deux moteurs n'ont ni la même puissance, ni la même vitesse de rotation en commun, ni les mêmes données nominales dans le tableau 1 ci-dessous:

Tableau 1 : exemple de données de deux moteurs

| Donnée nominale | Moteur 1 | Moteur 2 |
|---|---|---|
| donnée de puissance nominale du moteur (Pn) | 30 kW | 15 kW |
| donnée de tension nominale du moteur (Un) | 400 V | 380 V |
| donnée de courant nominal du moteur (In) | 56.3 A | 29.4 A |
| donnée de facteur de puissance du moteur (cosφ) | 0.84 | 0.88 |
| donnée de vitesse nominale du moteur (Wn) | 1460 tours/minute | 2930 tours/minute |

Pour pouvoir estimer la puissance délivrée par un moteur en fonction du courant qu'il consomme et de sa plaque signalétique, les inventeurs ont établi une relation entre leurs origines sur l'axe des abscisses (à puissance nulle) et les différentes données de la plaque signalétique.

Physiquement, le point d'origine de chaque courbe d'évolution de la puissance en fonction du courant réel représente la part de courant consommée par un moteur lorsque celui ne délivre aucune puissance, ce point particulier est noté I0 dans ce qui suit. C'est à partir de ce point qu'est calculée la courbe d'évolution de chaque moteur.

Les informations de la plaque signalétique des moteurs n'étant pas suffisantes pour construire un modèle électrique équivalent pour calculer la valeur du courant à vide I0, un algorithme génétique a été utilisé pour trouver une relation entre la plaque signalétique et les courants I0.

Suivant un mode de réalisation de l'invention, l'on calcule dans le calculateur la puissance active et/ou la puissance mécanique et/ou l'énergie active et/ou l'énergie mécanique selon au moins une deuxième fonction enregistrée dépendant au moins de la donnée de puissance nominale du moteur, de la donnée de courant nominal du moteur, du courant réel, du courant à vide ayant été calculé et d'un écart de la donnée de vitesse nominale du moteur par rapport à une valeur de référence prescrite de vitesse nominale du moteur.

Suivant un mode de réalisation, la valeur de référence prescrite de vitesse nominale du moteur est égale à 3000 tours par minute.

Les inventeurs ont déterminé que la première fonction pouvait être modélisée à une constante près par des facteurs multiplicatifs formés par la donnée de puissance nominale du moteur, la donnée de courant nominal du moteur, la donnée de tension nominale du moteur, la donnée de facteur de puissance du moteur et l'écart de la donnée de vitesse nominale du moteur par rapport à une valeur de référence prescrite de vitesse nominale du moteur, élevés chacun à un certain exposant respectif associé.

Ainsi, suivant un mode de réalisation, la première fonction comprend des facteurs multipliés entre eux, qui dépendent respectivement de la donnée de puissance nominale du moteur, de la donnée de courant nominal du moteur, de la donnée de tension nominale du moteur, de la donnée de facteur de puissance du moteur et de l'écart de la donnée de vitesse nominale du moteur par rapport à une valeur de référence prescrite de vitesse nominale du moteur.

Suivant un mode de réalisation, la première fonction est de la forme

$$I0 = (Pn)^{x1} \cdot (In)^{x2} \cdot (Un)^{x3} \cdot (\cos\varphi)^{x4} \cdot (REF\text{-}Wn)^{x5} + x6,$$

où I0 est le courant à vide du moteur,

Pn est la donnée de puissance nominale du moteur,

x1, x2, x3, x4, x5, x4, x5 et x6 sont des coefficients réels prescrits,

Pn est la donnée de puissance nominale du moteur,

In est la donnée de courant nominal du moteur,

Un est la donnée de tension nominale du moteur,

$\cos\varphi$ est la donnée de facteur de puissance du moteur.

Wn est la donnée de vitesse nominale du moteur,

REF est la valeur de référence prescrite de vitesse nominale du moteur.

Suivant un mode de réalisation,

x1 est un coefficient réel prescrit strictement négatif,

x2 est un coefficient réel prescrit strictement positif,

x3 est un coefficient réel prescrit strictement positif,

x4 est un coefficient réel prescrit strictement négatif,

x5 est un coefficient réel prescrit strictement négatif,

x6 est un coefficient réel prescrit strictement négatif.

L'algorithme a été paramétré de sorte que celui-ci cherche les valeurs des exposants de l'équation pour diminuer l'erreur totale sur le courant à vide.

Les résultats de simulation sur une centaine de moteurs aux caractéristiques variées ont été analysés pour établir la deuxième fonction.

Suivant un mode de réalisation, l'on calcule dans le calculateur la puissance mécanique Pm(t) du moteur par la deuxième fonction suivante :

$$Pm(t) = Pn \cdot \sqrt{\log\left(A \cdot \left(I_{red}(t)\right)^3 + B \cdot \left(I_{red}(t)\right)^2 + C \cdot \left(I_{red}(t)\right) + D\right)}$$

où Pn est la donnée de puissance nominale du moteur,

$$I_{red}(t) = \frac{I(t)}{In}$$

I(t) est le courant réel,

In est la donnée de courant nominal du moteur,

A, B, C et D sont des coefficients réels prescrits.

Suivant un mode de réalisation, les coefficients réels prescrits A, B, C et D sont différentes fonctions du courant à vide, ayant été calculé.

Suivant un mode de réalisation, le coefficient réel prescrit A est une exponentielle d'une première fonction polynomiale du courant (I0) à vide, ayant été calculé.

Les inventeurs ont ainsi déterminé qu'en interpolant l'exponentielle du carré de la courbe, le degré de la fonction polynomiale pouvait être de degré 3 et être moins sensible aux petites erreurs dans le calcul de ses coefficients, suivant un mode de réalisation.

Suivant un mode de réalisation, des corrélations ont été cherchées entre la valeur des coefficients A, B, C et D et les données signalétiques. Suivant un mode de réalisation, le coefficient A est interpolé en fonction du courant à vide et les coefficients B, C et D sont interpolés en fonction du coefficient A. Ainsi, suivant un premier mode de réalisation,

$$A = \exp((a_1 . (I0)^2 + a_2 . I0 + a_3)^2)$$

$$B = b_1 . A^2 + b_2 . A + b_3$$

$$C = c_1.A^2 + c_2.A + c_3$$

$$D = d_1.A^2 + d_2.A + d_3$$

où

$I0$ est le courant à vide du moteur,

$a_1$, $a_2$, $a_3$, $b_1$, $b_2$, $b_3$, $c_1$, $c_2$, $c_3$, $d_1$, $d_2$, $d_3$ sont des coefficients réels prescrits. Cela correspond par exemple à la première famille décrite ci-dessous.

Pour diminuer les écarts aux basses puissances et aux faibles valeurs du courant à vide, les coefficients de la deuxième fonction ont été recalés par une nouvelle interpolation sur la corrélation entre les coefficients A, B, C et D et la valeur du courant à vide issue de l'estimation. Ce recalage a modifié le calcul des coefficients A, B, C et D. Ainsi, suivant un deuxième mode de réalisation,

$$A = \exp((a_1.(I0)^4 + a_2.(I0)^3 + a_3.(I0)^2 + a_4.I0 + a_5)^2)$$

$$B = -\exp((b_1.(I0)^4 + b_2.(I0)^3 + b_3.(I0)^2 + b_4.I0 + b_5)^2)$$

$$C = \exp(c_1.(I0)^4 + c_2.(I0)^3 + c_3.(I0)^2 + c_4.I0 + c_5)$$

$$D = -\exp(d_1.(I0)^4 + d_2.(I0)^3 + d_3.(I0)^2 + d_4.I0 + d_5) + 1$$

où

$I0$ est le courant à vide du moteur,

$a_1$, $a_2$, $a_3$, $a_4$, $a_5$, $b_1$, $b_2$, $b_3$, $b_4$, $b_5$, $c_1$, $c_2$, $c_3$, $c_4$, $c_5$, $d_1$, $d_2$, $d_3$, $d_4$, $d_5$ sont des coefficients réels prescrits. Cela correspond par exemple à la deuxième famille décrite ci-dessous.

Suivant un mode de réalisation, l'on calcule la puissance active en fonction de la puissance mécanique, du courant réel, de la donnée de facteur de puissance du moteur, de la donnée de tension nominale du moteur et de la donnée de puissance nominale du moteur.

Suivant un mode de réalisation, l'on calcule la puissance active $P_{active}(t)$ selon les formules suivantes :

$$P_{active}(t) = P_m(t) + P_{pertes}(t)$$

$$P_{pertes}(t) = P_{pertesnom} \cdot \left( \frac{1}{3} + \frac{2 \cdot \left(I_{red}(t)\right)^2}{3} \right)$$

$$I_{red}(t) = \frac{I(t)}{In}$$

$$P_{pertesnom} = Pn \cdot \left( \frac{1}{\mathrm{Re}\,ndnom} - 1 \right)$$

$$\mathrm{Re}\,ndnom = \frac{Pn}{\sqrt{3}\cdot Un \cdot In \cdot \cos\varphi}$$

où $P_m(t)$ est la puissance mécanique,
I(t) est le courant réel,
Pn est la donnée de puissance nominale du moteur,
Un est la donnée de tension nominale du moteur,
In est la donnée de courant nominal du moteur,
$\cos\varphi$ est la donnée de facteur de puissance du moteur.

Suivant un mode de réalisation, l'on calcule la puissance active du moteur,
on calcule l'énergie active du moteur par intégration temporelle de la puissance active (Pe) du moteur.
Suivant un mode de réalisation, l'on calcule la puissance mécanique du moteur,
on calcule l'énergie mécanique du moteur par intégration temporelle de la puissance mécanique du moteur.
Un deuxième objet de l'invention est un programme d'ordinateur comportant des instructions de code pour la mise en œuvre du procédé de mesure tel que décrit ci-dessus, lorsqu'il est exécuté sur un calculateur.
Un troisième objet de l'invention est un dispositif de mesure d'une puissance active et/ou d'une puissance mécanique et/ou d'une énergie active et/ou d'une énergie mécanique d'un moteur électrique, le dispositif comportant :

au moins un capteur de mesure pour mesurer un courant réel du moteur par,
caractérisé en ce que le dispositif comporte en outre un calculateur comportant au moins une interface pour entrer au moins une donnée de puissance nominale du moteur, une donnée de vitesse nominale du moteur, une donnée de courant nominal du moteur, une donnée de tension nominale du moteur, une donnée de facteur de puissance du moteur et le courant réel du moteur,
le calculateur étant configuré pour calculer un courant à vide du moteur selon des premières fonctions enregistrées dépendant au moins de la donnée de puissance nominale du moteur, de la donnée de courant nominal du moteur, de la donnée de tension nominale du moteur et de la donnée de facteur de puissance du moteur,
le calculateur étant configuré pour calculer la puissance active et/ou la puissance mécanique et/ou l'énergie active et/ou l'énergie mécanique selon au moins une deuxième fonction enregistrée dépendant au moins de la donnée de puissance nominale du moteur, de la donnée de courant nominal du moteur, du courant réel et du courant à vide ayant été calculé,
le calculateur comportant une interface de sortie pour fournir la puissance active et/ou la puissance mécanique et/ou l'énergie active et/ou l'énergie mécanique, ayant été calculée.

L'invention sera mieux comprise à la lecture de la description qui va suivre, donnée uniquement à titre d'exemple non limitatif en référence aux dessins annexés, sur lesquels :

- la figure 1 représente schématiquement un dispositif de mesure suivant un mode de réalisation de l'invention,
- la figure 2 représente schématiquement un organigramme du procédé de mesure suivant un mode de réalisation de l'invention,
- la figure 3 représente des courbes d'évolution de la puissance en ordonnée en fonction du courant consommé de deux exemples de moteurs de l'état de la technique,
- la figure 4 représente des courbes de puissance estimée suivant un premier mode de réalisation de l'invention et la puissance mécanique délivrée et simulée pour différents moteurs respectifs,
- la figure 5 représente des courbes de puissance estimée suivant un deuxième mode de réalisation de l'invention et la puissance mécanique délivrée et simulée pour différents moteurs respectifs.

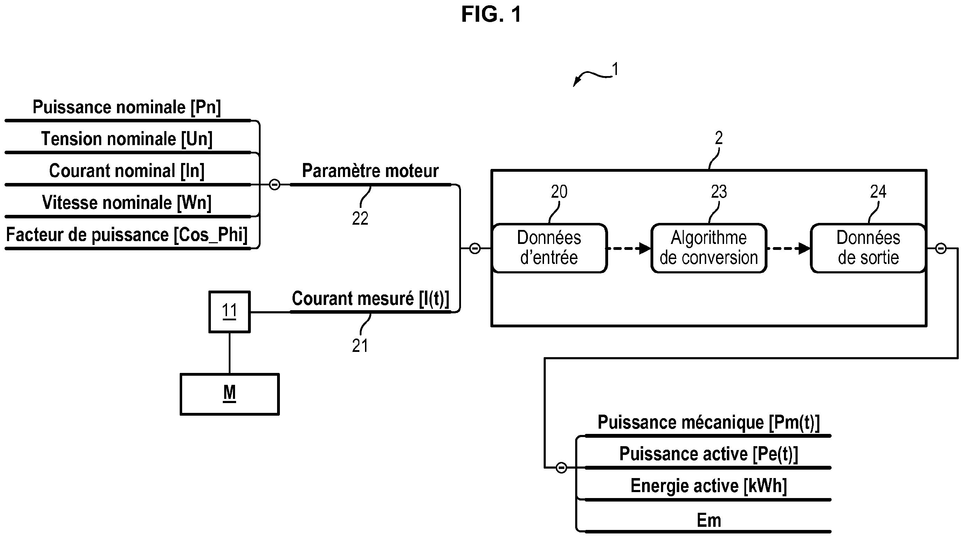

A la figure 1, le dispositif 1 de mesure suivant l'invention met en œuvre un procédé de mesure comportant une ou plusieurs des étapes mentionnées ci-dessous.
Le dispositif 1 de mesure comporte un ou plusieurs capteur(s) 11 de mesure, qui sont installés sur un ou plusieurs moteur(s) électrique(s) M et qui mesure(nt) un courant électrique réel I du moteur M, ce courant réel étant également noté I(t) et étant également appelé courant mesuré. Ce courant mesuré I ou I(t) peut être un courant réel instantané. Le ou les moteur(s) électrique(s) M peut être un moteur électrique asynchrone, notamment un moteur électrique asynchrone triphasé. Le moteur M peut être à alimentation directe, c'est-à-dire sans variateur de vitesse. Le moteur M peut avoir par exemple une vitesse de synchronisme de 1500 ou 3000 tours par minute. Le moteur M peut être à basse tension, par exemple inférieure ou égale à 1000 V. La valeur du courant réel mesuré I est envoyée à une première entrée 21 d'une interface 20 d'entrée d'un calculateur 2. La valeur du courant réel mesuré I est par exemple une valeur efficace (courant RMS) du courant électrique du moteur et peut être ponctuelle ou sur une période de temps. La première entrée 21 peut être une entrée en temps réel du courant mesuré I du moteur M. La première entrée 21 est reliée au capteur 11 par un organe de connexion, qui peut être un organe de connexion filaire ou un organe de connexion sans fil (c'est-à-dire comportant un récepteur qui est relié à la première entrée 21 et qui reçoit la valeur I de courant mesuré, envoyée via une liaison sans fil par un émetteur relié au capteur 11).

En outre, une donnée Pn de puissance nominale du moteur et une donnée Wn de vitesse nominale du moteur sont entrées sur une deuxième entrée 22 de l'interface 20. La donnée Wn de vitesse nominale du moteur est exprimée par exemple en tours par minute. La deuxième entrée 22 de l'interface 20 est par exemple une interface homme-machine, pouvant être manuelle pour entrer les données, et peut être par exemple un clavier d'ordinateur et/ou des touches manuelles et/ou un écran tactile ou autres. Suivant des modes de réalisation, une donnée Un de tension nominale du moteur, une donnée In de courant nominal du moteur et une donnée cosφ (également notée cos_Phi) de facteur de puissance du moteur sont également entrées sur la deuxième entrée 22 de l'interface 20. Les données sont par exemple entrées sur l'entrée 22 par l'utilisateur, qui pour ce faire a lu ces données sur une plaque signalétique du moteur M et qui actionne l'interface homme-machine. Ainsi, les données précitées sont appelées données nominales du moteur M ou données signalétiques du moteur M. Le dispositif 1 de mesure et le procédé de mesure peuvent utiliser un programme d'ordinateur comportant des instructions de code pour la mise en œuvre des étapes décrites.

Le calculateur 2 comporte un module 23 de calcul connecté à l'interface 20 et configuré pour calculer un courant à vide I0 du moteur selon une première fonction enregistrée dépendant au moins de la donnée de puissance nominale Pn du moteur, de la donnée In de courant nominal du moteur, de la donnée Un de tension nominale du moteur et de la donnée de facteur de puissance cosφ du moteur. La donnée de vitesse nominale Wn du moteur est différente d'une vitesse de synchronisme du moteur M, cette donnée de vitesse nominale Wn du moteur étant inférieure à la vitesse de synchronisme du moteur M.

Le module 23 de calcul est configuré pour calculer la valeur de la puissance active Pe (également notée Pe(t) ou $P_{active}(t)$) et/ou de la puissance mécanique Pm (également notée Pm(t) ou $P_m(t)$) du moteur électrique M et/ou de l'énergie active $E_{active}$ du moteur électrique M et/ou de l'énergie mécanique Em du moteur électrique M en fonction au moins du courant réel I. Ce calcul est effectué selon au moins une deuxième fonction enregistrée dépendant au moins de la donnée de puissance nominale Pn du moteur, de la donnée In de courant nominal du moteur, du courant réel I ayant été mesuré et du courant à vide I0 ayant été calculé. Cette deuxième fonction enregistrée peut également dépendre en plus d'un écart de la donnée de vitesse nominale Wn du moteur par rapport à une valeur de référence prescrite REF de vitesse nominale du moteur. La valeur de référence prescrite REF de vitesse nominale du moteur peut être entrée sur l'interface 20 ou être préenregistrée dans le calculateur 2 ou dans le module 23 de calcul. La donnée Wn de vitesse nominale du moteur est supérieure à zéro et peut être inférieure à la valeur de référence prescrite REF de vitesse nominale du moteur. Par exemple, la valeur de référence prescrite REF de vitesse nominale du moteur 3000 tours par minute, sans que cela soit limitatif. Dans ce cas, la donnée Wn de vitesse nominale du moteur peut être inférieure à 3000 tours par minute.

Le module 23 de calcul est connecté à une interface 24 de sortie du calculateur 2, sur laquelle sont fournies la valeur de la puissance active Pe et/ou de la puissance mécanique Pm et/ou de l'énergie active $E_{active}$ et/ou de l'énergie mécanique Em, ayant été calculée. Cette interface 24 de sortie peut être par exemple un écran ou un afficheur ou autres.

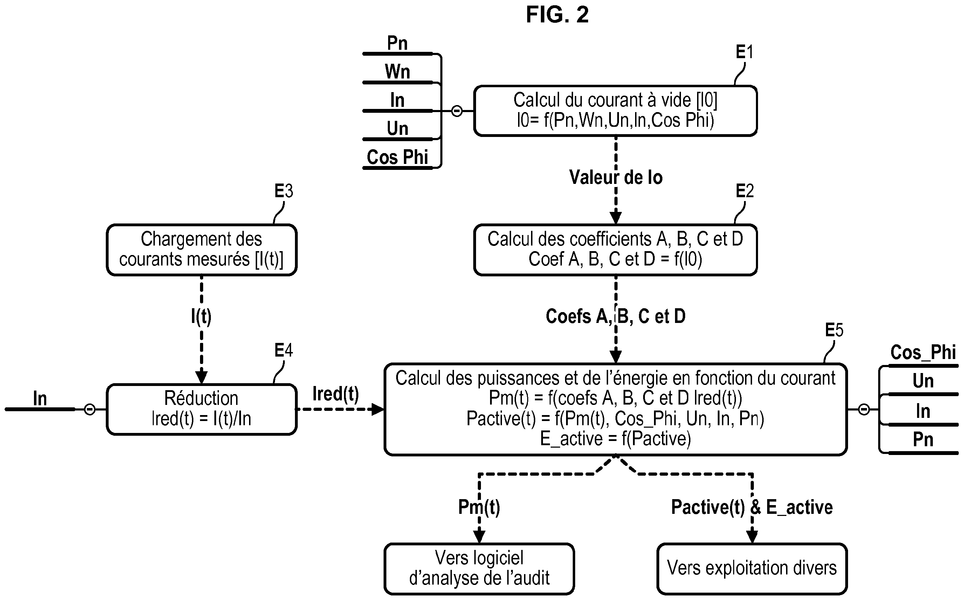

On décrit ci-dessous des modes de réalisation du calcul effectué par le module 23 de calcul du calculateur 2, en référence à la figure 2.

Suivant un mode de réalisation, la première fonction comprend des facteurs multipliés entre eux, qui dépendent respectivement de la donnée de puissance nominale Pn du moteur, de la donnée In de courant nominal du moteur, de la donnée Un de tension nominale du moteur, de la donnée de facteur de puissance coscp du moteur et de l'écart de la donnée de vitesse nominale Wn du moteur par rapport à la valeur de référence prescrite REF de vitesse nominale du moteur.

Suivant un mode de réalisation, chaque première fonction est de la forme

$$I0 = (Pn)^{x1}. (In)^{x2}. (Un)^{x3}. (cos\varphi)^{x4}.(REF\text{-}Wn)^{x5} + x6,$$

où I0 est le courant à vide du moteur,
Pn est la donnée de puissance nominale du moteur,
x1, x2, x3, x4, x5, x4, x5 et x6 sont des coefficients réels prescrits.

Suivant un mode de réalisation :

x1 est un coefficient réel prescrit strictement négatif,
x2 est un coefficient réel prescrit strictement positif,

x3 est un coefficient réel prescrit strictement positif,
x4 est un coefficient réel prescrit strictement négatif,
x5 est un coefficient réel prescrit strictement négatif,
x6 est un coefficient réel prescrit strictement négatif.

Suivant un mode de réalisation,

-2 < x1 < -1,
et/ou 1 < x2 < 2,
et/ou 1 < x3 < 2,
et/ou -2 < x4 < -1,
et/ou -1 < x5 < 0,
et/ou -1 < x6 < 0.

Suivant un mode de réalisation,

$-1.3 \leq x1 \leq -1.2$,
et/ou $1.2 \leq x2 \leq 1.3$,
et/ou $1.2 \leq x2 \leq 1.3$,
et/ou $-2 \leq x4 \leq -1.9$,
et/ou $-0.1 \leq x5 < 0$,
et/ou $-0.4 \leq x6 \leq -0.3$.

Suivant un mode de réalisation, $-1.24 \leq x1 \leq -1.23$,

et/ou $1.26 \leq x2 \leq 1.27$,
et/ou $1.22 \leq x2 \leq 1.23$,
et/ou $-1.91 \leq x4 \leq -1.9$,
et/ou $-0.02 \leq x5 \leq -0.01$,
et/ou $-0.33 \leq x6 \leq -0.32$.

Dans un exemple non limitatif, on peut avoir les valeurs suivantes de x1, x2, x3, x4, x5, x4, x5 et x6 :

x1 = -1.23,
x2 = 1.27,
x3 = 1.23,
x4 = -1.9,
x5 = -0.01,
x6 = -0.33.

Suivant un mode de réalisation, on réduit la valeur du courant mesuré I(t) en le divisant par la donnée In de courant nominal, pour obtenir un courant réduit $I_{red}(t)$ selon l'équation $I_{red}(t) = \dfrac{I(t)}{In}$ . Ainsi, les valeurs du courant réduit $I_{red}(t)$ pourront être contenues par exemple dans un intervalle entre zéro et un.

Suivant un mode de réalisation, le module 23 de calcul est configuré pour calculer la puissance mécanique Pm(t) du moteur par la deuxième fonction suivante :

$$Pm(t) = Pn \cdot \sqrt{\log\left(A \cdot \left(I_{red}(t)\right)^3 + B \cdot \left(I_{red}(t)\right)^2 + C \cdot \left(I_{red}(t)\right) + D\right)}$$

A, B, C et D sont des coefficients réels prescrits, préenregistrés dans le module 23 de calcul ou calculateur 2 et non nuls.

Les coefficients réels prescrits A, B, C et D peuvent être différentes fonctions du courant I0 à vide, ayant été calculé.

On décrit ci-dessous une première famille de modes de réalisation pour la deuxième fonction Pm(t).

Suivant un mode de réalisation,

$$A = \exp((a_1.(I0)^2 + a_2.I0 + a_3)^2)$$

$$B = b_1.A^2 + b_2.A + b_3$$

$$C = c_1.A^2 + c_2.A + c_3$$

$$D = d_1.A^2 + d_2.A + d_3$$

où

I0 est le courant à vide du moteur,
$a_1$, $a_2$, $a_3$, $b_1$, $b_2$, $b_3$, $c_1$, $c_2$, $c_3$, $d_1$, $d_2$, $d_3$ sont des coefficients réels prescrits, non nuls.

Dans les formules, exp désigne l'exponentielle.
Suivant un mode de réalisation,

$2 \leq a_1 \leq 3$, $-2 \leq a_2 \leq -1$, $1 \leq a_3 \leq 2$,
$-1 \leq b_1 < 0$, $-3 \leq b_2 \leq -2$, $3 \leq b_3 \leq 4$,
$0 < c_1 \leq 1$, $1 \leq c_2 \leq 2$, $-3 \leq c_3 \leq -2$,
$-1 \leq d_1 < 0$, $-1 \leq d_2 < 0$, $1 \leq d_3 \leq 2$.

Suivant un mode de réalisation,

$2.9 \leq a_1 \leq 3$, $-1.2 \leq a_2 \leq -1.1$, $1 \leq a_3 \leq 1.1$,
$-0.1 \leq b_1 < 0$, $-2.1 \leq b_2 \leq -2$, $3.5 \leq b_3 \leq 3.6$,
$0 < c_1 \leq 0.1$, $1.4 \leq c_2 \leq 1.5$, $-2.9 \leq c_3 \leq -2.8$,
$-0.1 \leq d_1 < 0$, $-0.5 \leq d_2 \leq -0.4$, $1.9 \leq d_3 \leq 2$.

Suivant un mode de réalisation,

$2.93 \leq a_1 \leq 2.94$, $-1.15 \leq a_2 \leq -1.14$, $1.06 \leq a_3 \leq 1.07$,
$-0.02 \leq b_1 \leq -0.01$, $-2.01 \leq b_2 \leq -2$, $3.51 \leq b_3 \leq 3.52$,
$0.02 \leq c_1 \leq 0.03$, $1.47 \leq c_2 \leq 1.48$, $-2.83 \leq c_3 \leq -2.82$,
$-0.01 \leq d_1 < 0$, $-0.46 \leq d_2 \leq -0.45$, $1.95 \leq d_3 \leq 1.96$.

Dans un exemple non limitatif, on peut avoir les valeurs suivantes

$$a_1 = 2.94,\ a_2 = -1.15,\ a_3 = 1.06,$$

$$b_1 = -0.02,\ b_2 = -2.01,\ b_3 = 3.51,$$

$$c_1 = 0.03,\ c_2 = 1.48,\ c_3 = -2.82,$$

$$d_1 = -0.01,\ d_2 = -0.046,\ d_3 = 1.96.$$

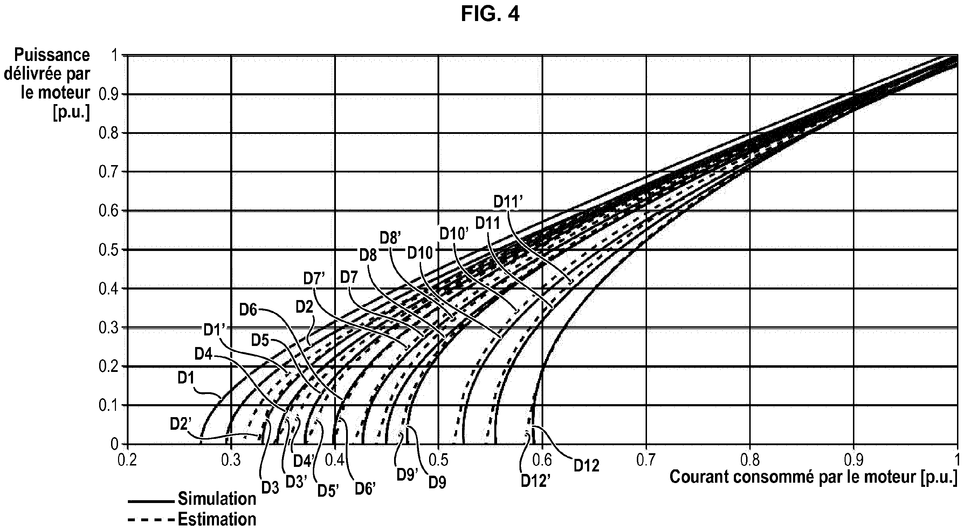

Cette première famille de coefficients a permis d'obtenir des formes de profil relativement proches de la puissance calculée selon cette deuxième fonction par rapport à la puissance simulée, ainsi que le montre la figure 4, représentant pour différents moteurs respectifs la courbe respective D1', D2', D3', D4', D5', D6', D7', D8', D9', D10',

D11', D12' de la puissance mécanique délivrée par le moteur, calculée (estimée) selon cette deuxième fonction par rapport au courant consommé par le moteur en abscisses, ainsi que la courbe respective D1, D2, D3, D4, D5, D6, D7, D8, D9, D10, D11, D12 de la puissance mécanique délivrée par le moteur, simulée.

On décrit ci-dessous une deuxième famille de modes de réalisation pour la deuxième fonction Pm(t).

Suivant un mode de réalisation, le coefficient réel prescrit A est une fonction croissante du courant I0 à vide, ayant été calculé,

le coefficient réel prescrit B est une fonction décroissante du courant I0 à vide, ayant été calculé,

le coefficient réel prescrit C est une fonction croissante du courant I0 à vide, ayant été calculé,

le coefficient réel prescrit D est une fonction décroissante du courant I0 à vide, ayant été calculé.

Suivant un mode de réalisation, le coefficient réel prescrit A est une exponentielle d'une première fonction polynomiale du courant I0 à vide, ayant été calculé.

Suivant un mode de réalisation, le coefficient réel prescrit B est égal à l'opposé d'une exponentielle d'une deuxième fonction polynomiale du courant I0 à vide, ayant été calculé.

Suivant un mode de réalisation, le coefficient réel prescrit C est une exponentielle d'une troisième fonction polynomiale du courant I0 à vide, ayant été calculé.

Suivant un mode de réalisation, le coefficient réel prescrit D est égale à la somme de un et de l'opposé d'une exponentielle d'une quatrième fonction polynomiale du courant I0 à vide, ayant été calculé.

Suivant un mode de réalisation, les première et deuxième fonctions polynomiales du courant I0 à vide sont chacune de degré inférieur ou égal à 8.

Suivant un mode de réalisation, les première et deuxième fonctions polynomiales du courant I0 à vide sont chacune de degré égal à 8.

Suivant un mode de réalisation, les troisième et quatrième fonctions polynomiales du courant I0 à vide sont chacune de degré inférieur ou égal à 4.

Suivant un mode de réalisation, les troisième et quatrième fonctions polynomiales du courant I0 à vide sont chacune de degré égal à 4.

Pour diminuer les écarts aux basses puissances et aux faibles valeurs du courant à vide, qui apparaissent à la figure 4, où on peut noter qu'il existe des écarts qui augmentent si la puissance diminue et qui sont d'autant plus grands que le courant à vide est faible, les coefficients de la deuxième fonction ont été recalés par une nouvelle interpolation sur la corrélation entre les coefficients A, B, C et D et la valeur du courant à vide issue de l'estimation. Ce recalage a modifié le calcul des coefficients A, B, C et D de la manière suivante.

Suivant un mode de réalisation,

$$A = \exp((a_1.(I0)^4 + a_2.(I0)^3 + a_3.(I0)^2 + a_4.I0 + a_5)^2).$$

Suivant un mode de réalisation,

$$B = - \exp((b_1.(I0)^4 + b_2.(I0)^3 + b_3.(I0)^2 + b_4.I0 + b_5)^2)$$

$$C = \exp(c_1.(I0)^4 + c_2.(I0)^3 + c_3.(I0)^2 + c_4.I0 + c_5)$$

$$D = - \exp(d_1.(I0)^4 + d_2.(I0)^3 + d_3.(I0)^2 + d_4.I0 + d_5) + 1$$

où

I0 est le courant à vide du moteur,

$a_1, a_2, a_3, a_4, a_5, b_1, b_2, b_3, b_4, b_5, c_1, c_2, c_3, c_4, c_5, d_1, d_2, d_3, d_4, d_5$ sont des coefficients réels prescrits, non nuls.

Suivant un mode de réalisation,

$29 \leq a_1 \leq 31$, $-59 \leq a_2 \leq -57$, $41 \leq a_3 \leq 43$, $-13 \leq a_4 \leq -11$, $1 \leq a_5 \leq 3$,
$36 \leq b_1 \leq 38$, $-63 \leq b_2 \leq -61$, $35 \leq b_3 \leq 37$, $-6 \leq b_4 \leq -4$, $0 < b_5 \leq 2$,
$171 \leq c_1 \leq 173$, $-311 \leq c_2 \leq -309$, $207 \leq c_3 \leq 209$, $-55 \leq c_4 \leq -53$, $3 \leq c_5 \leq 5$,

$160 \leq d_1 \leq 162$, $-284 \leq d_2 \leq -282$ , $181 \leq d_3 \leq 183$ , $-43 \leq d_4 \leq -41$ , $0 < d_5 \leq 2$.

Dans un exemple non limitatif, on peut avoir les valeurs suivantes de $a_1$, $a_2$, $a_3$, $a_4$, $a_5$, $b_1$, $b_2$, $b_3$, $b_4$, $b_5$, $c_1$, $c_2$, $c_3$, $c_4$, $c_5$, $d_1$, $d_2$, $d_3$, $d_4$, $d_5$:

$$a_1 = 31,\ a_2 = -58,\ a_3 = 42,\ a_4 = -12,\ a_5 = 2,$$

$$b_1 = 37,\ b_2 = -62,\ b_3 = 36,\ b_4 = -5,\ b_5 = 0,$$

$$c_1 = 172,\ c_2 = -310,\ c_3 = 208,\ c_4 = -54,\ c_5 = 4,$$

$$d_1 = 161,\ d_2 = -283,\ d_3 = 182,\ d_4 = -42,\ d_5 = 1.$$

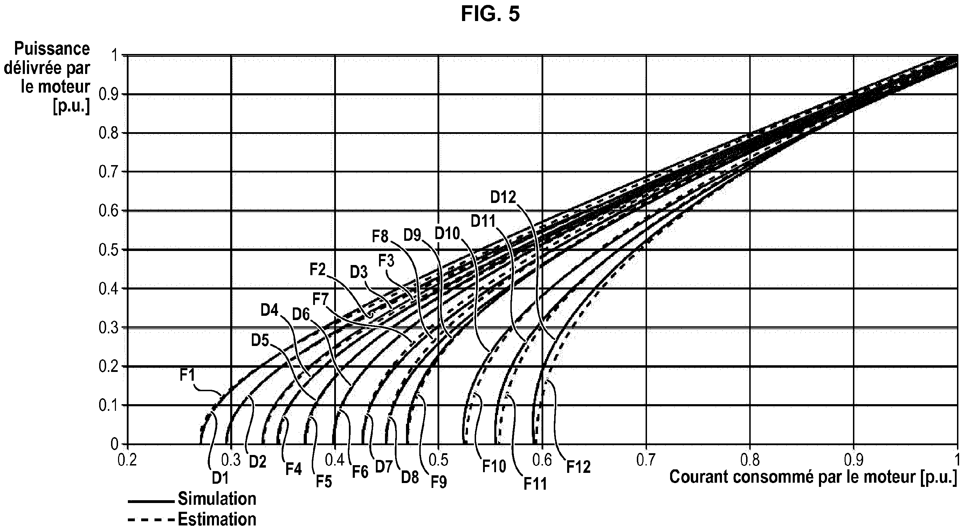

Cette deuxième famille de coefficients a permis d'obtenir que la puissance calculée selon cette deuxième fonction soit relativement fidèle à la puissance simulée, ainsi que le montre la figure 5, représentant pour différents moteurs respectifs la courbe respective F1, F2, F3, F4, F5, F6, F7, F8, F9, F10, F11, F12 de la puissance mécanique délivrée par le moteur, calculée (estimée) selon cette deuxième fonction par rapport au courant consommé par le moteur en abscisses, ainsi que la courbe respective D1, D2, D3, D4, D5, D6, D7, D8, D9, D10, D11, D12 de la puissance mécanique délivrée par le moteur, simulée.

Suivant un mode de réalisation, on calcule la puissance active $P_{active}(t)$ en fonction de la puissance mécanique $Pm$, du courant réel $I$, de la donnée $\cos\varphi$ de facteur de puissance du moteur, de la donnée de tension nominale $Un$ du moteur et de la donnée de puissance nominale $Pn$ du moteur.

Suivant un mode de réalisation, l'on calcule la puissance active $P_{active}(t)$ selon les formules suivantes :

$$P_{active}(t) = P_m(t) + P_{pertes}(t)$$

$$P_{pertes}(t) = P_{pertesnom} \cdot \left( \frac{1}{3} + \frac{2 \cdot (I_{red}(t))^2}{3} \right)$$

$$P_{pertesnom} = Pn \cdot \left( \frac{1}{\mathrm{Re}\,ndnom} - 1 \right)$$

$$\mathrm{Re}\,ndnom = \frac{Pn}{\sqrt{3} \cdot Un \cdot In \cdot \cos\varphi} \ ,$$

où Rendnom désigne le rendement du moteur M,
$P_{pertesnom}$ désigne les pertes au point nominal du moteur M,
$P_{pertes}(t)$ désigne les pertes calculées du moteur M.

Suivant un mode de réalisation, l'énergie active $E_{active}$ du moteur électrique M peut être calculée par intégration temporelle de la puissance active Pe ayant été calculée, selon l'équation suivante :

$$E_{active} = \int_0^t P_{active}(t) \cdot dt \quad ,$$

où t désigne le temps.

Suivant un mode de réalisation, l'énergie mécanique Em du moteur électrique M peut être calculée par intégration temporelle de la puissance mécanique Pm ayant été calculée, selon l'équation suivante :

$$Em = \int_{0}^{t} Pm(t) \cdot dt \quad ,$$

où t désigne le temps.

Suivant un mode de réalisation, on applique par le calculateur 2 l'algorithme suivant :

- au cours d'une étape E1, calcul du courant à vide I0,
- au cours d'une étape E2, calcul des coefficients A, B, C et D,
- au cours d'une étape E3, mesure du courant réel I ou I(t),
- au cours d'une étape E4, réduction du courant I pour calculer le courant réduit $I_{red}(t)$,
- au cours d'une étape E5, calcul de la puissance active Pe et/ou de la puissance mécanique Pm et/ou de l'énergie active $E_{active}$ et/ou de l'énergie mécanique Em en fonction au moins du courant réduit $I_{red}(t)$ ayant été calculé au cours de l'étape E4 et des coefficients A, B, C, D calculés au cours de l'étape E2.

L'algorithme peut fonctionner par exemple uniquement pour les machines électriques asynchrones avec des vitesses de synchronisme de 1500 et 3000 tours par minute.

La puissance mécanique Pm ayant été calculée peut être utilisée par un dispositif d'analyse, tel que par exemple un logiciel d'analyse de l'audit.

La puissance active Pe et l'énergie active $E_{active}$ ayant été calculées peuvent être utilisées par un ou plusieurs dispositifs d'exploitation. L'invention permet ainsi de convertir le courant mesuré I en valeur de la puissance active Pe et/ou de la puissance mécanique Pm et/ou de l'énergie active $E_{active}$ et/ou de l'énergie mécanique Em.

Bien entendu, les modes de réalisation, possibilités, caractéristiques et exemples ci-dessus peuvent être combinés l'un avec l'autre ou être sélectionnés indépendamment l'un de l'autre.

## Revendications

1. Procédé de mesure d'une puissance active (Pe) et/ou d'une puissance mécanique (Pm) et/ou d'une énergie active et/ou d'une énergie mécanique d'un moteur électrique, dans lequel

   on mesure un courant réel (I) du moteur par au moins un capteur de mesure,
   on entre sur au moins une interface (20) d'entrée d'un calculateur au moins une donnée de puissance nominale (Pn) du moteur, une donnée de vitesse nominale (Wn) du moteur, une donnée (In) de courant nominal du moteur, une donnée (Un) de tension nominale du moteur, une donnée de facteur de puissance (cosφ) du moteur et le courant réel (I) du moteur,
   on calcule dans le calculateur un courant à vide (I0) du moteur selon une première fonction enregistrée dépendant au moins de la donnée de puissance nominale (Pn) du moteur, de la donnée (In) de courant nominal du moteur, de la donnée (Un) de tension nominale du moteur et de la donnée de facteur de puissance (coscp) du moteur,
   on calcule dans le calculateur la puissance active (Pe) et/ou la puissance mécanique (Pm) et/ou l'énergie active et/ou l'énergie mécanique selon au moins une deuxième fonction enregistrée dépendant au moins de la donnée de puissance nominale (Pn) du moteur, de la donnée (In) de courant nominal du moteur, du courant réel (I) et du courant à vide (I0) ayant été calculé,
   on fournit sur une interface (24) de sortie du calculateur la puissance active (Pe) et/ou la puissance mécanique (Pm) et/ou l'énergie active et/ou l'énergie mécanique, ayant été calculée.

2. Procédé suivant la revendication 1, **caractérisé en ce que** l'on calcule dans le calculateur la puissance active (Pe) et/ou la puissance mécanique (Pm) et/ou l'énergie active et/ou l'énergie mécanique selon au moins une deuxième fonction enregistrée dépendant au moins de la donnée de puissance nominale (Pn) du moteur, de la donnée (In) de courant nominal du moteur, du courant réel (I), du courant à vide (I0) ayant été calculé et d'un écart de la donnée de vitesse nominale (Wn) du moteur par rapport à une valeur de référence prescrite (REF) de vitesse nominale du moteur.

3. Procédé suivant la revendication 2, **caractérisé en ce que** la première fonction comprend des facteurs multipliés entre eux, qui dépendent respectivement de la donnée de puissance nominale (Pn) du moteur, de la donnée (In)

de courant nominal du moteur, de la donnée (Un) de tension nominale du moteur, de la donnée de facteur de puissance (cosφ) du moteur et de l'écart de la donnée de vitesse nominale (Wn) du moteur par rapport à une valeur de référence prescrite (REF) de vitesse nominale du moteur.

4. Procédé suivant la revendication 2 ou 3, **caractérisé en ce que** la valeur de référence prescrite (REF) de vitesse nominale du moteur est égale à 3000 tours par minute.

5. Procédé suivant l'une quelconque des revendications 2 à 4, **caractérisé en ce que** la première fonction est de la forme

$$I0 = (Pn)^{x1} . (In)^{x2} . (Un)^{x3} . (\cos\varphi)^{x4} . (REF-Wn)^{x5} + x6,$$

où I0 est le courant à vide du moteur,
Pn est la donnée de puissance nominale du moteur,
x1, x2, x3, x4, x5, x4, x5 et x6 sont des coefficients réels prescrits,
Pn est la donnée de puissance nominale du moteur,
In est la donnée de courant nominal du moteur,
Un est la donnée de tension nominale du moteur,
cosφ est la donnée de facteur de puissance du moteur.
Wn est la donnée de vitesse nominale du moteur,
REF est la valeur de référence prescrite de vitesse nominale du moteur.

6. Procédé suivant la revendication 5, **caractérisé en ce que**

x1 est un coefficient réel prescrit strictement négatif,
x2 est un coefficient réel prescrit strictement positif,
x3 est un coefficient réel prescrit strictement positif,
x4 est un coefficient réel prescrit strictement négatif,
x5 est un coefficient réel prescrit strictement négatif,
x6 est un coefficient réel prescrit strictement négatif.

7. Procédé suivant l'une quelconque des revendications 1 à 6, **caractérisé en ce que** l'on calcule dans le calculateur la puissance mécanique Pm(t) du moteur par la deuxième fonction suivante :

$$Pm(t) = Pn \cdot \sqrt{\log\left(A \cdot \left(I_{red}(t)\right)^3 + B \cdot \left(I_{red}(t)\right)^2 + C \cdot \left(I_{red}(t)\right) + D\right)}$$

où
Pn est la donnée de puissance nominale du moteur,

$$I_{red}(t) = \frac{I(t)}{In}$$

I(t) est le courant réel,
In est la donnée de courant nominal du moteur,
A, B, C et D sont des coefficients réels prescrits.

8. Procédé suivant la revendication 7, **caractérisé en ce que** les coefficients réels prescrits A, B, C et D sont différentes fonctions du courant (I0) à vide, ayant été calculé.

9. Procédé suivant la revendication 7 ou 8, **caractérisé en ce que**
le coefficient réel prescrit A est une exponentielle d'une première fonction polynomiale du courant (I0) à vide, ayant été calculé.

10. Procédé suivant l'une quelconque des revendications 7 à 9, **caractérisé en ce que**

$$A = \exp((a_1.(I0)^2 + a_2.I0 + a_3)^2)$$

$$B = b_1.A^2 + b_2.A + b_3$$

$$C= c_1.A^2 + c_2.A + c_3$$

$$D= d_1.A^2 + d_2.A + d_3$$

où

I0 est le courant à vide du moteur,
$a_1$, $a_2$, $a_3$, $b_1$, $b_2$, $b_3$, $c_1$, $c_2$, $c_3$, $d_1$, $d_2$, $d_3$ sont des coefficients réels prescrits.

**11.** Procédé suivant l'une quelconque des revendications 7 à 9, **caractérisé en ce que**

$$A = \exp((a_1.(I0)^4 + a_2.(I0)^3 + a_3.(I0)^2 + a_4.I0 + a_5)^2)$$

$$B = - \exp((b_1.(I0)^4 + b_2.(I0)^3 + b_3.(I0)^2 + b_4.I0 + b_5)^2)$$

$$C= \exp(c_1.(I0)^4 + c_2.(I0)^3 + c_3.(I0)^2 + c_4.I0 + c_5)$$

$$D= - \exp(d_1.(I0)^4 + d_2.(I0)^3 + d_3.(I0)^2 + d_4.I0 + d_5) + 1$$

où

I0 est le courant à vide du moteur,
$a_1$, $a_2$, $a_3$, $a_4$, $a_5$, $b_1$, $b_2$, $b_3$, $b_4$, $b_5$, $c_1$, $c_2$, $c_3$, $c_4$, $c_5$ , $d_1$, $d_2$, $d_3$ , $d_4$, $d_5$ sont des coefficients réels prescrits.

**12.** Procédé suivant l'une quelconque des revendications précédentes, **caractérisé en ce que** l'on calcule la puissance active ($P_{active}(t)$) en fonction de la puissance mécanique (Pm), du courant réel (I), de la donnée de facteur de puissance (coscp) du moteur, de la donnée de tension nominale (Un) du moteur et de la donnée de puissance nominale (Pn) du moteur.

**13.** Procédé suivant la revendication 12, **caractérisé en ce que** l'on calcule la puissance active $P_{active}(t)$ selon les formules suivantes :

$$P_{active}(t) = P_m(t) + P_{pertes}(t)$$

$$P_{pertes}(t) = P_{pertesnom} \cdot \left( \frac{1}{3} + \frac{2 \cdot (I_{red}(t))^2}{3} \right)$$

$$I_{red}(t) = \frac{I(t)}{In}$$

$$P_{pertesnom} = Pn \cdot \left( \frac{1}{\mathrm{Re}\, ndnom} - 1 \right)$$

$$\mathrm{Re}\, ndnom = \frac{Pn}{\sqrt{3} \cdot Un \cdot In \cdot \cos\varphi}$$

où $P_m(t)$ est la puissance mécanique,
$I(t)$ est le courant réel,
Pn est la donnée de puissance nominale du moteur,
Un est la donnée de tension nominale du moteur,
In est la donnée de courant nominal du moteur,
$\cos\varphi$ est la donnée de facteur de puissance du moteur.

14. Procédé de suivant l'une quelconque des revendications précédentes, **caractérisé en ce que** l'on calcule la puissance active (Pe) du moteur,
on calcule l'énergie active du moteur par intégration temporelle de la puissance active (Pe) du moteur.

15. Procédé suivant l'une quelconque des revendications précédentes, **caractérisé en ce que** l'on calcule la puissance mécanique (Pm) du moteur,
on calcule l'énergie mécanique du moteur par intégration temporelle de la puissance mécanique (Pm) du moteur.

16. Dispositif de mesure d'une puissance active (Pe) et/ou d'une puissance mécanique (Pm) et/ou d'une énergie active et/ou d'une énergie mécanique d'un moteur électrique, le dispositif comportant :

au moins un capteur (11) de mesure pour mesurer un courant réel (I) du moteur par, un calculateur (2) comportant au moins une interface (20) pour entrer au moins une donnée de puissance nominale (Pn) du moteur, une donnée de vitesse nominale (Wn) du moteur, une donnée (In) de courant nominal du moteur, une donnée (Un) de tension nominale du moteur, une donnée de facteur de puissance (cosφ) du moteur et le courant réel (I) du moteur,
le calculateur (2) étant configuré pour calculer un courant à vide (I0) du moteur selon des premières fonctions enregistrées dépendant au moins de la donnée de puissance nominale (Pn) du moteur, de la donnée (In) de courant nominal du moteur, de la donnée (Un) de tension nominale du moteur et de la donnée de facteur de puissance (cosφ) du moteur,
le calculateur (2) étant configuré pour calculer la puissance active (Pe) et/ou la puissance mécanique (Pm) et/ou l'énergie active et/ou l'énergie mécanique selon au moins une deuxième fonction enregistrée dépendant au moins de la donnée de puissance nominale (Pn) du moteur, de la donnée (In) de courant nominal du moteur, du courant réel (I) et du courant à vide (I0) ayant été calculé,
le calculateur (2) comportant une interface (24) de sortie pour fournir la puissance active (Pe) et/ou la puissance mécanique (Pm) et/ou l'énergie active et/ou l'énergie mécanique, ayant été calculée.

17. Programme d'ordinateur comportant des instructions de code pour la mise en oeuvre du procédé de mesure suivant l'une quelconque des revendications 1-15, lorsqu'il est exécuté sur un dispositif selon la revendication 16.

**Patentansprüche**

1. Verfahren zur Messung einer aktiven Leistung (Pe) und/oder einer mechanischen Leistung (Pm) und/oder einer aktiven Energie und/oder einer mechanischen Energie eines Elektromotors, wobei

von mindestens einem Messsensor ein Ist-Strom (I) des Motors gemessen wird,
auf mindestens einer Eingabeschnittstelle (20) eines Rechners mindestens ein Datenelement der Nennleistung (Pn) des Motors, ein Datenelement der Nenndrehzahl (Wn) des Motors, ein Datenelement (In) des Nennstroms des Motors, ein Datenelement (Un) der Nennspannung des Motors, ein Datenelement des Leistungsfaktors (cosφ) des Motors und der Ist-Strom (I) des Motors eingegeben werden,
im Rechner ein Leerlaufstrom (I0) des Motors gemäß einer gespeicherten ersten Funktion in Abhängigkeit mindestens vom Datenelement der Nennleistung (Pn) des Motors, vom Datenelement (In) des Nennstroms des Motors, vom Datenelement (Un) der Nennspannung des Motors und vom Datenelement des Leistungsfaktors (cosφ) des Motors berechnet wird,

im Rechner die aktive Leistung (Pe) und/oder die mechanische Leistung (Pm) und/oder die aktive Energie und/oder die mechanische Energie gemäß mindestens einer gespeicherten zweiten Funktion in Abhängigkeit von mindestens vom Datenelement der Nennleistung (Pn) des Motors, vom Datenelement (In) des Nennstroms des Motors, vom Ist-Strom (I) und vom berechneten Leerlaufstrom (I0) berechnet wird,

auf einer Ausgangsschnittstelle (24) des Rechners die aktive Leistung (Pe) und/oder die mechanische Leistung (Pm) und/oder die aktive Energie und/oder die mechanische Energie bereitgestellt wird, die berechnet wurde.

2. Verfahren nach Anspruch 1, **dadurch gekennzeichnet, dass** im Rechner die aktive Leistung (Pe) und/oder die mechanische Leistung (Pm) und/oder die aktive Energie und/oder die mechanische Energie gemäß mindestens einer gespeicherten zweiten Funktion berechnet wird, die mindestens vom Datenelement der Nennleistung (Pn) des Motors, vom Datenelement (In) des Nennstroms des Motors, vom Ist-Strom (I), vom berechneten Leerlaufstrom (I0) und von einer Abweichung des Datenelements der Nenndrehzahl (Wn) des Motors im Verhältnis zu einem vorgeschriebenen Referenzwert (REF) der Nenndrehzahl des Motors abhängt.

3. Verfahren nach Anspruch 2, **dadurch gekennzeichnet, dass** die erste Funktion miteinander multiplizierte Faktoren umfasst, die jeweils vom Datenelement der Nennleistung (Pn) des Motors, vom Datenelement (In) des Nennstroms des Motors, vom Datenelement (Un) der Nennspannung des Motors, vom Datenelement des Leistungsfaktors (cosφ) des Motors und von der Abweichung des Datenelements der Nenndrehzahl (Wn) des Motors im Verhältnis zu einem vorgeschriebenen Referenzwert (REF) der Nenndrehzahl des Motors abhängen.

4. Verfahren nach Anspruch 2 oder 3, **dadurch gekennzeichnet, dass** der vorgeschriebene Referenzwert (REF) der Nenndrehzahl des Motors gleich 3000 Umdrehungen pro Minute ist.

5. Verfahren nach einem beliebigen der Ansprüche 2 bis 4, **dadurch gekennzeichnet, dass** die erste Funktion folgendermaßen lautet

$$I0 = (Pn)^{x1} \cdot (In)^{x2} \cdot (Un)^{x3} \cdot (\cos\varphi)^{x4} \cdot (REF\text{-}Wn)^{x5} + x6,$$

wobei I0 der Leerlaufstrom des Motors ist,
Pn das Datenelement der Nennleistung des Motors ist,
x1, x2, x3, x4, x5, x4, x5 und x6 reale vorgeschriebene Koeffizienten sind,
Pn das Datenelement der Nennleistung des Motors ist,
In das Datenelement des Nennstroms des Motors ist,
Un das Datenelement der Nennspannung des Motors ist,
cosφ das Datenelement des Leistungsfaktors des Motors ist,
Wn das Datenelement der Nenndrehzahl des Motors ist,
REF der vorgeschriebene Referenzwert der Nenndrehzahl des Motors ist.

6. Verfahren nach Anspruch 5, **dadurch gekennzeichnet, dass**

x1 ein vorgeschriebener realer strikt negativer Koeffizient ist,
x2 ein vorgeschriebener realer strikt positiver Koeffizient ist,
x3 ein vorgeschriebener realer strikt positiver Koeffizient ist,
x4 ein vorgeschriebener realer strikt negativer Koeffizient ist,
x5 ein vorgeschriebener realer strikt negativer Koeffizient ist,
x6 ein vorgeschriebener realer strikt negativer Koeffizient ist.

7. Verfahren nach einem beliebigen der Ansprüche 1 bis 6, **dadurch gekennzeichnet, dass** im Rechner die mechanische Leistung Pm(t) des Motors durch die folgende zweite Funktion berechnet wird:

$$Pm(t) = Pn \cdot \sqrt{\log\left(A \cdot \left(I_{red}(t)\right)^3 + B \cdot \left(I_{red}(t)\right)^2 + C \cdot \left(I_{red}(t)\right) + D\right)}$$

wobei

Pn das Datenelement der Nennleistung des Motors ist,

$$I_{red}(t) = \frac{I(t)}{In}$$

I(t) der Ist-Strom ist,
In das Datenelement des Nennstroms des Motors ist, A, B, C und D vorgeschriebene reale Koeffizienten sind.

8. Verfahren nach Anspruch 7, **dadurch gekennzeichnet, dass** die vorgeschriebenen realen Koeffizienten A, B, C und D verschiedene Funktionen des berechneten Leerlaufstroms (I0) sind.

9. Verfahren nach Anspruch 7 oder 8, **dadurch gekennzeichnet, dass**
der vorgeschriebene reale Koeffizient A ein Exponent einer ersten polynominalen Funktion des berechneten Leerstroms (I0) ist.

10. Verfahren nach einem beliebigen der Ansprüche 7 bis 9, **dadurch gekennzeichnet, dass**

$$A = \exp((a_1.(I0)^2 + a_2.I0 + a_3)^2)$$

$$B = b_1.A^2 + b_2.A + b_3$$

$$C = c_1.A^2 + c_2.A + c_3$$

$$D = d_1.A^2 + d_2.A + d_3$$

wobei

I0 der Leerlaufstrom des Motors ist,
$a_1$, $a_2$, $a_3$, $b_1$, $b_2$, $b_3$, $c_1$, $c_2$, $c_3$, $d_1$, $d_2$, $d_3$ vorgeschriebene reale Koeffizienten sind.

11. Verfahren nach einem beliebigen der Ansprüche 7 bis 9, **dadurch gekennzeichnet, dass**

$$A = \exp((a_1.(I0)^4 + a_2.(I0)^3 + a_3.(I0)^2 + a_4.I0 + a_5)^2)$$

$$B = -\exp((b_1.(I0)^4 + b_2.(I0)^3 + b_3.(I0)^2 + b_4.I0 + b_5)^2)$$

$$C = \exp(c_1.(I0)^4 + c_2.(I0)^3 + c_3.(I0)^2 + c_4.I0 + c_5)$$

$$D = -\exp(d_1.(I0)^4 + d_2.(I0)^3 + d_3.(I0)^2 + d_4.I0 + d_5) + 1$$

wobei

I0 der Leerlaufstrom des Motors ist,
$a_1$, $a_2$, $a_3$, $a_4$, $a_5$, $b_1$, $b_2$, $b_3$, $b_4$, $b_5$, $c_1$, $c_2$, $c_3$, $c_4$, $c_5$, $d_1$, $d_2$, $d_3$, $d_4$, $d_5$ vorgeschriebene reale Koeffizienten sind.

12. Verfahren nach einem beliebigen der vorangehenden Ansprüche, **dadurch gekennzeichnet, dass** die aktive Leistung ($P_{active}(t)$) in Abhängigkeit von der mechanischen Leistung (Pm), vom Ist-Strom (I), vom Datenelement des Leistungsfaktors ($\cos\varphi$) des Motors, vom Datenelement der Nennspannung (Un) des Motors und vom Datenelement der Nennleistung (Pn) des Motors berechnet wird.

**13.** Verfahren nach Anspruch 12, **dadurch gekennzeichnet, dass** die aktive Leistung $P_{active}(t)$ gemäß den folgenden Formeln berechnet wird:

$$P_{active}(t) = P_m(t) + P_{pertes}(t)$$

$$P_{pertes}(t) = P_{pertesnom} \cdot \left( \frac{1}{3} + \frac{2 \cdot (I_{red}(t))^2}{3} \right)$$

$$I_{red}(t) = \frac{I(t)}{In}$$

$$P_{pertesnom} = Pn \cdot \left( \frac{1}{\mathrm{Re}\,ndnom} - 1 \right)$$

$$\mathrm{Re}\,ndnom = \frac{Pn}{\sqrt{3} \cdot Un \cdot In \cdot \cos\varphi}$$

wobei $P_m(t)$ die mechanische Leistung ist,

I(t) der Ist-Strom ist,
Pn das Datenelement der Nennleistung des Motors ist,
Un das Datenelement der Nennspannung des Motors ist,
In das Datenelement des Nennstroms des Motors ist, $\cos\varphi$ das Datenelement des Leistungsfaktors des Motors ist.

**14.** Verfahren nach einem beliebigen der vorangehenden Ansprüche, **dadurch gekennzeichnet, dass** die aktive Leistung (Pe) des Motors berechnet wird,
die aktive Energie des Motors durch zeitliche Integration der aktiven Leistung (Pe) des Motors berechnet wird.

**15.** Verfahren nach einem beliebigen der vorangehenden Ansprüche, **dadurch gekennzeichnet, dass** die mechanische Leistung (Pm) des Motors berechnet wird,
die mechanische Energie des Motors durch zeitliche Integration der mechanischen Leistung (Pm) des Motors berechnet wird.

**16.** Vorrichtung zur Messung einer aktiven Leistung (Pe) und/oder einer mechanischen Leistung (Pm) und/oder einer aktiven Energie und/oder einer mechanischen Energie eines Elektromotors, wobei die Vorrichtung aufweist:

mindestens einen Messsensor (11) zum Messen eines Ist-Stroms (I) des Motors,
einen Rechner (2), der mindestens eine Schnittstelle (20) zum Eingeben mindestens eines Datenelements der Nennleistung (Pn) des Motors, eines Datenelements der Nenndrehzahl (Wn) des Motors, eines Datenelements (In) des Nennstroms des Motors, eines Datenelements (Un) der Nennspannung des Motors, eines Datenelements des Leistungsfaktors ($\cos\varphi$) des Motors und des Ist-Stroms (I) des Motors aufweist,
wobei der Rechner (2) ausgelegt ist, um einen Leerlaufstrom (I0) des Motors gemäß gespeicherten ersten Funktionen in Abhängigkeit von mindestens vom Datenelement der Nennleistung (Pn) des Motors, vom Datenelement (In) des Nennstroms des Motors, vom Datenelement (Un) der Nennspannung des Motors und vom Datenelement des Leistungsfaktors ($\cos\varphi$) des Motors zu berechnen,
wobei der Rechner (2) ausgelegt ist, um die aktive Leistung (Pe) und/oder die mechanische Leistung (Pm) und/oder die aktive Energie und/oder die mechanische Energie gemäß mindestens einer gespeicherten zweiten Funktion in Abhängigkeit mindestens vom Datenelement der Nennleistung (Pn) des Motors, vom Datenelement (In) des Nennstroms des Motors, vom Ist-Strom (I) und vom berechneten Leerlaufstrom (I0) zu berechnen,
wobei der Rechner (2) eine Ausgangsschnittstelle (24) aufweist, um die aktive Leistung (Pe) und/oder die mechanische Leistung (Pm) und/oder die aktive Energie und/oder die mechanische Energie bereitzustellen, die berechnet wurde.

**17.** Rechnerprogramm, aufweisend Codebefehle für die Umsetzung des Messverfahrens nach einem beliebigen der Ansprüche 1-15, wenn es auf einer Vorrichtung nach Anspruch 16 ausgeführt wird.

**Claims**

**1.** A method for measuring an active power (Pe) and/or a mechanical power (Pm) and/or an active energy and/or a mechanical energy of an electric motor, wherein

a real current (I) of the motor is measured by at least one measurement sensor,
at least a nominal power datum (Pn) of the motor, a nominal speed datum (Wn) of the motor, a nominal current datum (In) of the motor, a nominal voltage datum (Un) of the motor, a power factor datum (cosφ) of the motor and the real current (I) of the motor are inputted on at least one input interface (20) of a calculator,
a no-load current (I0) of the motor is calculated in the calculator according to a first recorded function depending at least on the nominal power datum (Pn) of the motor, on the nominal current datum (In) of the motor, on the nominal voltage datum (Un) of the motor and on the power factor datum (cosφ) of the motor,
the active power (Pe) and/or the mechanical power (Pm) and/or the active energy and/or the mechanical energy are/is calculated in the calculator according to at least one second recorded function depending at least on the nominal power datum (Pn) of the motor, on the nominal current datum (In) of the motor, on the real current (I) and on the no-load current (I0) having been calculated,
the active power (Pe) and/or the mechanical power (Pm) and/or the active energy and/or the mechanical energy, having been calculated, are/is provided on an output interface (24) of the calculator.

**2.** The method according to claim 1, **characterized in that** the active power (Pe) and/or the mechanical power (Pm) and/or the active energy and/or the mechanical energy are/is calculated in the calculator according to at least one second recorded function depending at least on the nominal power datum (Pn) of the motor, on the nominal current datum (In) of the motor, on the real current (I), on the no-load current (I0) having been calculated and on a deviation of the nominal speed datum (Wn) of the motor from a prescribed reference value (REF) of the nominal speed of the motor.

**3.** The method according to claim 2, **characterized in that** the first function comprises factors multiplied together, which depend respectively on the nominal power datum (Pn) of the motor, on the nominal current datum (In) of the motor, on the nominal voltage datum (Un) of the motor, on the power factor datum (cosφ) of the motor and on the deviation of the nominal speed datum (Wn) of the motor from a prescribed reference value (REF) of the nominal speed of the motor.

**4.** The method according to claim 2 or 3, **characterized in that** the prescribed reference value (REF) of the nominal speed of the motor is equal to 3000 revolutions per minute.

**5.** The method according to any one of claims 2 to 4, **characterized in that** the first function is of the form

$$I0 = (Pn)^{x1} \cdot (In)^{x2} \cdot (Un)^{x3} \cdot (\cos\varphi)^{x4} \cdot (REF\text{-}Wn)^{x5} + x6,$$

where I0 is the no-load current of the motor,
Pn is the nominal power datum of the motor,
x1, x2, x3, x4, x5, x4, x5 and x6 are prescribed real coefficients,
Pn is the nominal power datum of the motor,
In is the nominal current datum of the motor,
Un is the nominal voltage datum of the motor,
cosφ is the power factor datum of the motor.
Wn is the nominal speed datum of the motor,
REF is the prescribed reference value of the nominal speed of the motor.

**6.** The method according to claim 5, **characterized in that**

x1 is a strictly negative prescribed real coefficient,
x2 is a strictly positive prescribed real coefficient,
x3 is a strictly positive prescribed real coefficient,
x4 is a strictly negative prescribed real coefficient,
x5 is a strictly negative prescribed real coefficient,
x6 is a strictly negative prescribed real coefficient.

7. The method according to any one of claims 1 to 6, **characterized in that** the mechanical power Pm(t) of the motor is calculated in the calculator by the following second function:

$$Pm(t) = Pn \cdot \sqrt{\log\left(A \cdot \left(I_{red}(t)\right)^3 + B \cdot \left(I_{red}(t)\right)^2 + C \cdot \left(I_{red}(t)\right) + D\right)}$$

where
Pn is the nominal power datum of the motor,

$$I_{red}(t) = \frac{I(t)}{In}$$

I(t) is the real current,
In is the nominal current datum of the motor,
A, B, C and D are prescribed real coefficients.

8. The method according to claim 7, **characterized in that** the prescribed real coefficients A, B, C and D are different functions of the no-load current (I0), having been calculated.

9. The method according to claim 7 or 8, **characterized in that**
the prescribed real coefficient A is an exponential of a first polynomial function of the no-load current (I0), having been calculated.

10. The method according to any one of claims 7 to 9, **characterized in that**

$$A = \exp((a_1.(I0)^2 + a_2.I0 + a_3)^2)$$

$$B = b_1.A^2 + b_2.A + b_3$$

$$C = c_1.A^2 + c_2.A + c_3$$

$$D = d_1.A^2 + d_2.A + d_3$$

where

I0 is the no-load current of the motor,
$a_1$, $a_2$, $a_3$, $b_1$, $b_2$, $b_3$, $c_1$, $c_2$, $c_3$, $d_1$, $d_2$, $d_3$ are prescribed real coefficients.

11. The method according to any one of claims 7 to 9, **characterized in that**

$$A = \exp((a_1.(I0)^4 + a_2.(I0)^3 + a_3.(I0)^2 + a_4.I0 + a_5)^2)$$

$$B = - \exp((b_1.(I0)^4 + b_2.(I0)^3 + b_3.(I0)^2 + b_4.I0 + b_5)^2)$$

$$C = \exp(c_1.(I0)^4 + c_2.(I0)^3 + c_3.(I0)^2 + c_4.I0 + c_5)$$

$$D = -\exp(d_1.(I0)^4 + d_2.(I0)^3 + d_3.(I0)^2 + d_4.I0 + d_5) + 1$$

where

I0 is the no-load current of the motor,

$a_1$, $a_2$, $a_3$, $a_4$, $a_5$, $b_1$, $b_2$, $b_3$, $b_4$, $b_5$, $c_1$, $c_2$, $c_3$, $c_4$, $c_5$, $d_1$, $d_2$, $d_3$, $d_4$, $d_5$ are prescribed real coefficients.

12. The method according to any one of the preceding claims, **characterized in that** the active power ($P_{active}(t)$) is calculated according to the mechanical power (Pm), the real current (I), the power factor datum ($\cos\varphi$) of the motor, the nominal voltage datum (Un) of the motor and the nominal power datum (Pn) of the motor.

13. The method according to claim 12, **characterized in that** the active power $P_{active}(t)$ is calculated according to the following formulas:

$$P_{active}(t) = P_m(t) + P_{pertes}(t)$$

$$P_{pertes}(t) = P_{pertesnom} \cdot \left( \frac{1}{3} + \frac{2 \cdot \left( I_{red}(t) \right)^2}{3} \right)$$

$$I_{red}(t) = \frac{I(t)}{In}$$

$$P_{pertesnom} = Pn \cdot \left( \frac{1}{\mathrm{Re}\,ndnom} - 1 \right)$$

$$\mathrm{Re}\,ndnom = \frac{Pn}{\sqrt{3} \cdot Un \cdot In \cdot \cos\varphi}$$

where $P_m(t)$ is the mechanical power,
I(t) is the real current,
Pn is the nominal power datum of the motor,
Un is the nominal voltage datum of the motor,
In is the nominal current datum of the motor,
$\cos\varphi$ is the power factor datum of the motor.

14. The method according to any one of the preceding claims, **characterized in that** the active power (Pe) of the motor is calculated,
the active energy of the motor is calculated by temporal integration of the active power (Pe) of the motor.

15. The method according to any one of the preceding claims, **characterized in that** the mechanical power (Pm) of the motor is calculated,
the mechanical energy of the motor is calculated by temporal integration of the mechanical power (Pm) of the motor.

16. A device for measuring an active power (Pe) and/or a mechanical power (Pm) and/or an active energy and/or a mechanical energy of an electric motor, the device comprising:

at least one measurement sensor (11) for measuring a real current (I) of the motor by,
**characterized in that** the device further comprises a calculator (2) comprising at least one interface (20) for inputting at least a nominal power datum (Pn) of the motor, a nominal speed datum (Wn) of the motor, a nominal current datum (In) of the motor, a nominal voltage datum (Un) of the motor, a power factor datum (cosφ) of the motor and the real current (I) of the motor,

the calculator (2) being configured to calculate a no-load current (I0) of the motor according to first recorded functions depending at least on the nominal power datum (Pn) of the motor, on the nominal current datum (In) of the motor, on the nominal voltage datum of the motor (Un) and on the power factor datum (cosφ) of the motor, the calculator (2) being configured to calculate the active power (Pe) and/or the mechanical power (Pm) and/or the active energy and/or the mechanical energy according to at least one second recorded function depending at least on the nominal power datum (Pn) of the motor, the nominal current datum (In) of the motor, the real current (I) and the no-load current (I0) having been calculated,

the calculator (2) comprising an output interface (24) for providing the active power (Pe) and/or the mechanical power (Pm) and/or the active energy and/or the mechanical energy, having been calculated.

17. A computer program comprising code instructions for the implementation of the measurement method according to any one of claims 1-15, when it is executed on a device according to claim 16.

**FIG. 1**

Puissance nominale [Pn]
Tension nominale [Un]
Courant nominal [In]
Vitesse nominale [Wn]
Facteur de puissance [Cos_Phi]

Paramètre moteur
22

11

Courant mesuré [I(t)]
21

M

2

20 — Données d'entrée
23 — Algorithme de conversion
24 — Données de sortie

1

Puissance mécanique [Pm(t)]
Puissance active [Pe(t)]
Energie active [kWh]
Em

EP 3 729 109 B1

## FIG. 2

Pn
Wn
In
Un
Cos Phi

**E1** Calcul du courant à vide [I0]
I0= f(Pn,Wn,Un,In,Cos Phi)

**Valeur de Io**

**E3** Chargement des courants mesurés [I(t)]

**E2** Calcul des coefficients A, B, C et D
Coef A, B, C et D = f(I0)

**I(t)**

**Coefs A, B, C et D**

In

**E4** Réduction
Ired(t) = I(t)/In

**Ired(t)**

**E5** Calcul des puissances et de l'énergie en fonction du courant
Pm(t) = f(coefs A, B, C et D Ired(t))
Pactive(t) = f(Pm(t), Cos_Phi, Un, In, Pn)
E_active = f(Pactive)

Cos_Phi
Un
In
Pn

**Pm(t)**

**Pactive(t) & E_active**

Vers logiciel d'analyse de l'audit

Vers exploitation divers

EP 3 729 109 B1

## FIG. 3

Puissance délivrée par le moteur [p.u.] (vertical axis, 0 to 1)

Courant consommé par le moteur [p.u.] (horizontal axis, 0.4 to 1)

C1

C2

EP 3 729 109 B1

FIG. 4

EP 3 729 109 B1

FIG. 5

Puissance délivrée par le moteur [p.u.]

Courant consommé par le moteur [p.u.]

—— Simulation

- - - - Estimation

EP 3 729 109 B1

## RÉFÉRENCES CITÉES DANS LA DESCRIPTION

**Documents brevets cités dans la description**

- FR 2999326 A